# EUROPÄISCHE PATENTSCHRIFT

(11) **EP 0 630 543 B1**
(45) Veröffentlichungstag und Bekanntmachung des Hinweises auf die Patenterteilung: **22.11.1995**
(21) Anmeldenummer: 93905068.8
(22) Anmeldetag: 03.03.1993
(51) Int. Cl.: H04M 19/02, H04M 19/00, H04B 3/54, H03F 1/02

(54) **SCHALTUNGSANORDNUNG ZUR ÜBERTRAGUNG VON KLEINEN, ENERGIEARMEN UND GROSSEN, WESENTLICH ENERGIEREICHEREN SIGNALEN**
CIRCUIT FOR TRANSMITTING SMALL, LOW ENERGY SIGNALS AND LARGE, ESSENTIALLY HIGHER ENERGY SIGNALS
CIRCUIT POUR LA TRANSMISSION DE PETITS SIGNAUX DE FAIBLE ENERGIE ET DE GRANDS SIGNAUX SENSIBLEMENT DE PLUS HAUTE ENERGIE

(30) Priorität: 04.03.1992 AT 414/92
(43) Veröffentlichungstag der Anmeldung: 28.12.1994
(73) Patentinhaber: SEMCOTEC HANDELSGESELLSCHAFT M.B.H., A-1030 Wien (AT)
(72) Erfinder: KAUSEL, Wilfried, A-1180 Wien (AT); KREMSER, Hannes, A-1120 Wien (AT); STALLBAUMER, Hermann, A-1100 Wien (AT); WINKLER, Werner, A-1050 Wien (AT)
(74) Vertreter: Gibler, Ferdinand, Dipl.Ing. Dr. techn.
(86) Internationale Anmeldenummer: AT9300035
(87) Internationale Veröffentlichungsnummer: WO9318609

(56) Entgegenhaltungen:
- EP-A- 0 399 997
- EP-A- 0 408 137
- FR-A- 2 596 596
- US-A- 4 371 840
- ELECTRONICS & WIRELESS WORLD, Bd. 93, Nr. 1614, 1987, SUTTON,SURREY - GB Seiten 415 - 420, B. FRIEDMAN: 'Modulated-pulse amplifiers revived'

## Beschreibung

Die Erfindung bezieht sich auf eine Schaltungsanordnung zur Übertragung von kleinen, energiearmen und großen, wesentlich energiereicheren Signalen insbesondere zur Übertragung von Sprachsignalen mit einem Gleichsignal für die Fernspeisung einer Empfängerschaltung oder mit einem energiereichen Wechselsignal, z.B. einer Rufwechselspannung für eine Signalisierung, bei der ein Operationsverstarker mit vorgegebener Verstärkung vorgesehen ist, an dessen einem Eingang ein Pol einer das kleine Signal liefernde Quelle angelegt ist und dessen Betriebsspannungseingänge mit einer Versorgungsspannungsquelle verbunden ist.

Derzeit wird die Überlagerung z.B. von Sprachsignalen und Speisespannung meist mit Hilfe eines Transformators durchgeführt, wobei die z.B. eine Rufwechselspannung bei einem Telefonsystem überhaupt über ein Relais den Teilnehmerleitungen zugeführt wird. Während dieser Zeit ist die Sprachsignalquelle von den Teilnehmerleitungen gänzlich abgetrennt. Da sowohl Transformatoren als auch Relais relativ große und teure Bauteile sind und vor allem Relais als mechanische Bauteile dem Verschleiß stark ausgesetzt sind, ergeben sich durch die Verwendung solcher Bauteile entsprechende Nachteile.

Mit den bekannten SLIC (subscriber line interface circuit) wird eine Lösung dieses Problems in der Weise versucht, daß die Teilnehmerleitungen von integrierten Verstärkern angesteuert werden, wobei der Ausgangsspannungsbereich dieser Verstärker den gesamten Klein- und Großsignalaussteuerbereich der Teilnehmerleitung enthalten muß. Die Schaltkreise müssen daher in einer Technologie aufgebaut werden, deren Spannungsfestigkeit dem größten auftretenden Signal entsprechen muß. Das sind typischerweise 48V bis 60V für die Fernspeisung und bis zu 180V_{PP} für die Rufwechselspannung, wogegen die Sprachwechselspannung im Bereich von 2 - 3V_{PP} liegt. Bei dieser Realisierung ergibt sich jedoch zwangsläufig der Nachteil einer sehr großen Verlustleistung an den 180V Operationsverstärkern, wobei auch aufgrund der erforderlichen Spannungsfestigkeit sehr große Transistoren verwendet werden müssen, sodaß nur wenige Funktionen auf einem Chip vertretbarer Größe integriert werden können.

Gemäß EP-A 0 399 997 ist auch schon vorgeschlagen worden, die Rufwechselspannung über Optokoppler in den die Sprachsignale übertragenden Verstärker einzuspeisen. Jedoch verbleibt bei diesem Vorschlag das Problem der Übertragung der Gleichspannungen für den Betrieb der Empfängerschaltung nach wie vor bestehen.

Ziel der Erfindung ist es, diese Nachteile zu vermeiden und eine Schaltungsanordnung der eingangs erwähnten Art vorzuschlagen, die es auf einfache Weise ermöglicht energiearme schwache Signale, z.B. Sprechsignale, und energiereiche Signale und Gleichspannungen auf einer Teilnehmerleitung zu übertragen, ohne daß hiezu Transformatoren und Relais erforderlich wären und bei der auch auf besonders spannungsfeste Operationsverstärker verzichtet werden kann.

Erfindungsgemäß wird dies dadurch erreicht, daß der zweite Pol der die energiearmen Signale liefernden Quelle (2) mit dem zweiten Eingang des Operationsverstärkers (1), ein Pol einer energiereichere Signale liefernden Quelle (3) mit einem Pol der Versorgungsspannungsquelle (V), und der zweite Pol der energiereichere Signale liefernden Quelle (3) mit dem Bezugspotential verbunden ist, wobei die Abnahme der Ausgangsspannung (Va) gegen dieses Bezugspotential erfolgt, und wobei die Versorgungsspannungsquelle (V) von diesem Bezugspotential unabhängig ist.

Durch diese Maßnahmen ist es z.B. möglich eine oder beide Adern einer Teilnehmerleitung in einem Telefonsystem von Operationsverstärkern anzusteuern, deren Aussteuerbereich und damit auch deren Versorgungsspannung, die die auftretende Verlustleistung wesentlich mitbestimmt, nur auf die auftretenden kleinen Signale, z.B. des Sprachsignales, abgestimmt sind, und die von den übrigen Schaltungsteilen so isoliert sind, daß deren Versorgungsspannungsbezugspotential mit einer Quelle der energiereichen Signale verbunden werden kann.

Die Übertragung der Sprachsignale auf die Differenzspannungseingänge des bzw. der isolierten Verstärker kann dabei in beliebiger Weise, z.B. kapazitiv, galvanisch oder optisch, entweder analog oder digital moduliert oder unmoduliert erfolgen.

Zur Vergrößerung der Spannungsaussteuerbarkeit eines Operationsverstärkers wurde auch schon vorgeschlagen, die Versorgungsspannung auf die Ausgangsspannung zu beziehen, wobei die Versorgungsspannungsquelle mit dem Ausgang des Operationsverstärkers verbunden ist.

Nach einem weiteren Merkmal der Erfindung kann vorgesehen sein, daß ein Pol der energiereicheren Signale liefernden Quelle mit einem Eingang des Operationsvertärkers verbunden ist, mit dem auch ein Pol der Versorgungsspannungsquelle in Verbindung steht.

Durch diese Maßnahmen ergibt sich ein sehr einfacher Aufbau der erfindungsgemäßen Schaltungsanordnung.

Weiters kann auch vorgesehen sein, daß ein Pol der energiereichere Signale liefernden Quelle mit einem Betriebsspannungseingang des Operationsverstärkers verbunden ist.

Dadurch kommt es zu einer Überlagerung der Versorgungsspannung mit den energiereicheren Signalen.

Nach einem weiteren Merkmal der Erfindung kann vorgesehen sein, daß die energiereichere Signale liefernde Quelle durch einen getakteten Spannungswandler gebildet ist, an dessen Steuereingang ein Steuersignal anliegt.

Auf diese Weise ergibt sich ein sehr hoher Wirkungsgrad der Quelle für die energiereicheren Signale, wodurch keine speziellen Bauformen von Kühlkörpern erfoderlich sind.

Die Erfindung wird nun anhand der Zeichnung näher erläutert. Dabei zeigen:
Fig. 1 schematisch eine erste Ausführungsform einer erfindungsgemäßen Schaltungsanordnung,
Fig. 2 schematisch eine weitere Ausführungsform einer erfindungsgemäßen Schaltungsanordnung, und
Fig. 3 schematisch eine Quelle zur Erzeugung eines energiereichen Signales.

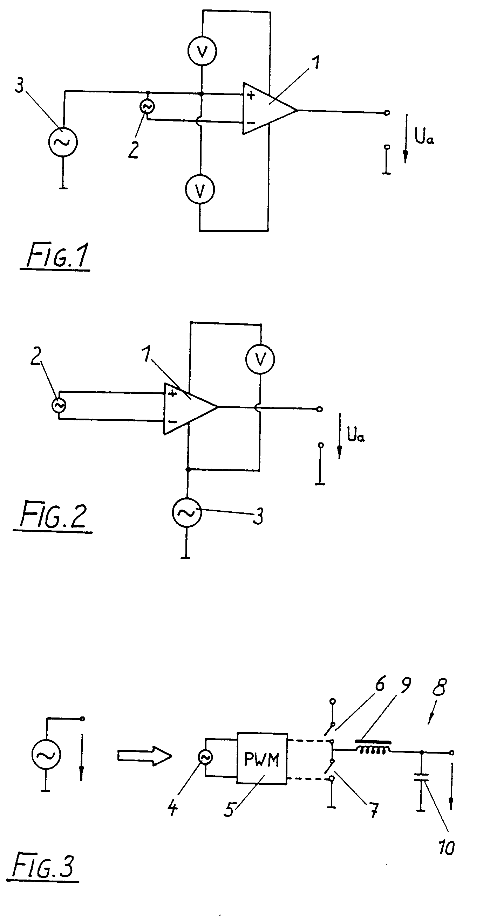

Bei der Ausführungsform nach der Fig. 1 ist an die beiden Signaleingänge + und - eines Operationsverstärkers 1 mit vorgegebener Verstärkung eine Signalquelle 2 zur Erzeugung kleiner, energiearmer Signale angeschlossen. Weiters ist an den Signaleingang + des Operationsverstärkers 1 auch noch eine Quelle 3 zur Lieferung von energiereichen Signalen mit einem ihrer Pole angeschlossen.

An diesem Eingang + des Operationsverstärkers 1 sind auch die einen Pole zweier Versorgungsspannungsquellen V1, V2 angeschlossen, wodurch die Versorgungsspannung auf den Eingang des Operationsverstärkers 1 bezogen ist.

Die Verstärkung des Operationsverstärkers 1 kann dadurch vorgegeben werden, daß der Ausgang des Operationsverstärkers 1 über einen Widerstand an den invertierenden Eingang "←" rückgekoppelt ist und die Signalquelle 2 über einen Widerstand an diesem Eingang angeschlossen ist.

Die Abnahme der Ausgangsspannung Uₐ erfolgt gegen das Bezugspotential der Quelle 3 zur Lieferung der energiereichen Signale.

Bei der Ausführungsform nach der Fig. 2 ist die Quelle 2 zur Lieferung der energiearmen Signale ebenfalls mit dem invertierenden Eingang - und dem nicht-invertierenden Ein gang des Operationsverstärkers 1 verbunden. Die Quelle 3 zur Lieferung der energiereichen Signale ist bei dieser Ausführungsform jedoch mit einem Betriebsspannungseingang des Operationsverstärkers 1 verbunden, an welchem Eingang auch ein Pol einer Versorgungsspannungsquelle V angeschlossen ist, deren zweiter Pol mit dem zweiten Betriebsspannungseingang des Operationsverstärkers 1 verbunden ist.

Auch bei dieser Ausführungsform erfolgt die Abnahme der Ausgangsspannung Uₐ gegen das Bezugspotential der Quelle 3 zur Lieferung der energiereichen Signale.

Ein Beispiel einer Quelle 3 zur Lieferung von energiereichen Signalen ist in der Fig. 3 dargestellt.

Bei dieser Ausführungsform steuert eine Signalquelle 4, die schwache Signale liefert, einen Pulsweitenmodulator 5, der Schalter 6 und 7, die üblicherweise als elektronische Schalter ausgebildet sind, eines getakteten Spannungswandlers 8 steuert. Dieser Spannungswandler kann in beliebiger Weise ausgebildet sein. Bei der dargestellten Ausführungsform ist der Spannungswandler 8 durch eine Reihenschaltung einer Drossel 9 und eines Kondensators 10 gebildet, wobei die Abnahme der verstärkten Signalspannung an dem Verbindungspunkt der Drossel 9 mit dem Kondensator 10 gegen ein Bezugspotenial erfolgt.

## Patentansprüche

1. Schaltungsanordnung zur Übertragung von kleinen, energiearmen und großen, wesentlich energiereicheren Signalen insbesondere zur Übertragung von Sprachsignalen mit einem Gleichsignal für die Fernspeisung einer Empfängerschaltung oder mit einem energiereichen Wechselsignal, z.B. einer Rufwechselspannung für eine Signalisierung, bei der ein Operationsverstärker (1) mit vorgegebener Verstärkung vorgesehen ist, an dessen einem Eingang ein Pol einer das energiearme Signal liefernde Quelle (2) angelegt ist und dessen Betriebsspannungseingänge mit einer Versorgungsspannungsquelle (V) verbunden sind, **dadurch gekennzeichnet,** daß der zweite Pol der die energiearmen Signale liefernden Quelle (2) mit dem zweiten Eingang des Operationsverstärkers (1), ein Pol einer energiereichere Signale liefernden Quelle (3) mit einem Pol der Versorgungsspannungsquelle (V), und der zweite Pol der energiereichere Signale liefernden Quelle (3) mit dem Bezugspotential verbunden ist, wobei die Abnahme der Ausgangsspannung (Va) gegen dieses Bezugspotential erfolgt, und wobei die Versorgungsspannungsquelle (V) von diesem Bezugspotential unabhängig ist.

2. Schaltungsanordnung nach Anspruch 1, **dadurch gekennzeichnet**, daß ein Pol der energiereicherere Signale liefernden Quelle (3) mit einem Eingang des Operationsverstärkers (1) verbunden ist, mit dem auch ein Pol der Versorgungsspannungsquelle (V1, V2) in Verbindung steht.

3. Schaltungsanordnung nach Anspruch 1, **dadurch gekennzeichnet,** daß ein Pol der energiereichere Signale liefernden Quelle (3) mit einem Betriebsspannungseingang des Operationsverstärkers (1) verbunden ist.

4. Schaltungsanordnung nach einem der Ansprüche 1 bis 3, **dadurch gekennzeichnet**, daß die energiereichere Signale liefernde Quelle (3) durch einen getakteten Spannungswandler (8) gebildet ist, an dessen Steuereingang ein Steuersignal anliegt.

## Claims

1. Circuit arrangement for the transmission of small low-power signals and large, essentially higher-power signals, in particular for the transmission of voice signals, with a DC signal for the remote power feeding of a receiver circuit or with a high-power AC signal, for example an AC ringing voltage for signalling, in the case of which there is provided an operational amplifier (1) which has a predetermined gain, to one input of which there is connected one pole of a source (2) supplying the low-power signal and the operating voltage inputs of which are connected to a supply voltage source (V), characterized in that the second pole of the source (2) supplying the low-power signals is connected to the second input of the operational amplifier (1), one pole of a source (3) supplying higher-power signals is connected to a pole of the supply voltage source (V), and the second pole of the source (3) supplying higher-power signals is connected to the reference potential, the decrease in the output voltage (Va) taking place with respect to this reference potential and the supply voltage source (V) being independent of this reference potential.

2. Circuit arrangement according to Claim 1, characterized in that one pole of the source (3) supplying higher-power signals is connected to an input of the operational amplifier (1), to which one pole of the supply voltage source (V1, V2) is also connected.

3. Circuit arrangement according to Claim 1, characterized in that one pole of the source (3) supplying higher-power signals is connected to an operating voltage input of the operational amplifier (1).

4. Circuit arrangement according to one of Claims 1 to 3, characterized in that the source (3) supplying higher-power signals is formed by a clocked voltage transformer (8), at the control input of which a control signal is present.

## Revendications

1. Montage pour la transmission de petits signaux à faible énergie et de grands signaux à beaucoup plus haute énergie, en particulier pour la transmission de signaux vocaux avec un signal continu pour l'alimentation à distance d'un circuit récepteur ou avec un signal alternatif à haute énergie, par exemple une tension alternative d'appel pour une signalisation, dans lequel est prévu un amplificateur opérationnel (1) à amplification fixée à une entrée duquel est appliqué un pôle d'une source (2) fournissant le signal à faible énergie et dont les entrées de tension de fonctionnement sont reliées à une source de tension d'alimentation (V), caractérisé par le fait que le second pôle de la source (2) fournissant les signaux à faible énergie est relié à la deuxième entrée de l'amplificateur opérationnel (1), un pôle d'une source (3) fournissant des signaux à plus haute énergie est relié à un pôle de la source de tension d'alimentation (V) et de second pôle de la source (3) fournissant des signaux à plus haute énergie est relié au potentiel de référence, la tension de sortie (Va) étant prise par rapport à ce potentiel de référence et la source de tension d'alimentation (V) étant indépendante de ce potentiel de référence.

2. Montage selon la revendication 1, caractérisé par le fait qu'un pôle de la source (3) fournissant des signaux à plus haute énergie est relié à une entrée de l'amplificateur opérationnel (1), à laquelle est aussi relié un pôle de la source de tension d'alimentation (V1, V2).

3. Montage selon la revendication 1, caractérisé par le fait qu'un pôle de la source (3) fournissant des signaux à plus haute énergie est relié à une entrée de tension de fonctionnement de l'amplificateur opérationnel (1).

4. Montage selon l'une des revendications 1 à 3, caractérisé par le fait que la source (3) fournissant des signaux à plus haute énergie est formée par un transformateur de tension rythmé (8) à l'entrée de commande duquel est appliqué un signal de commande.
